# EUROPÄISCHE PATENTSCHRIFT

(11) **EP 2 067 257 B1**
(45) Veröffentlichungstag und Bekanntmachung des Hinweises auf die Patenterteilung: **25.04.2012**
(21) Anmeldenummer: 07820530.9
(22) Anmeldetag: 24.09.2007
(51) Int. Cl.: G06F 3/02, H01H 25/04

(54) **EINGABEEINHEIT FÜR ELEKTROTECHNISCHE GERÄTE**
INPUT UNIT FOR ELECTROTECHNICAL DEVICES
UNITÉ D'ENTRÉE POUR APPAREILS ÉLECTROTECHNIQUES

(30) Priorität: 29.09.2006 DE 102006046202
(43) Veröffentlichungstag der Anmeldung: 10.06.2009
(73) Patentinhaber: Siemens Enterprise Communications GmbH & Co. KG, 81379 München (DE)
(72) Erfinder: BOLLMANN, Stefan, 46499 Hamminkeln (DE); LERNER, Achim, 46325 Borken (DE); RAUBER, Jens, 44227 Dortmund (DE)
(74) Vertreter: Fritzsche, Thomas
(86) Internationale Anmeldenummer: PCT/EP2007/060124
(87) Internationale Veröffentlichungsnummer: WO 2008/040657

(56) Entgegenhaltungen:
- EP-A- 1 589 407
- WO-A-2005/076117
- DE-A1- 10 308 514
- DE-U1-212004 000 044
- US-A1- 2002 190 727
- US-A1- 2004 253 931
- US-A1- 2005 259 085

## Beschreibung

Die Erfindung betrifft eine Eingabeeinheit für elektrotechnische Geräte gemäß dem Oberbegriff des Anspruchs 1.

Eingabeeinheiten für elektrotechnische Geräte dienen dazu, in das elektrotechnische Gerät Dateninformationen einzugeben oder darin eine gewünschte Funktion auszulösen. Letztlich werden durch solche Eingabeeinheiten Eingangssignale für das elektrotechnische Gerät gesteuert, die der jeweiligen Maßgabe entsprechen und in Abhängigkeit dieser dann das elektrotechnische Gerät seine Arbeit bewerkstelligt.

Allgemein sind Eingabeeinheiten bekannt, die mit dem menschlichen Finger bedienbare Komponenten zur elektromechanischen und/oder elektronischen Erzeugung von solchen Eingangssignalen aufweisen, mit denen dann eine entsprechende kontrollierte Steuerung des elektrotechnischen Geräts durchgeführt wird.

Im Speziellen ist aus dem Dokument DE 21 2004 000 044 U1 ein kapazitiver Positionssensor bekannt, der für elektronische Geräte eingesetzt wird. Der kapazitive Positionssensor weist mit dem menschlichen Finger bedienbare Komponenten zur elektromechanischen und/oder elektronischen Erzeugung von Eingangssignalen für eine kontrollierte Steuerung des elektrotechnischen Geräts basierend auf diesen erzeugten Eingangssignalen auf, wobei für die Fingerberührung eine für kapazitive Feldübertragungen geeignete Abdeckung vorgesehen ist. Die Abdeckung weist einen Berührbereich für eine Berührung an mehr als an einer einzigen Stelle auf. Direkt unterhalb der Abdeckung ist eine Sensorfolie mit einer über drei Kontaktstellen elektrisch kontaktierbaren Widerstandsstruktur vorgesehen, die kontinuierlich kapazitiv in Abhängigkeit von der momentanen Stelle der Berührung der Abdeckung durch den menschlichen Finger reagiert und eine jeweilige entsprechende Widerstandsgröße einstellt. Diese Widerstandsgröße ist an den drei Kontaktstellen abgreifbar und zur Erzeugung eines jeweiligen zugehörigen Eingangssignals für das elektrotechnische Gerät zu dessen jeweils entsprechender Steuerung heranziehbar.

Aus dem Dokument DE 103 08 514 A1 ist eine Berührungssensor-Anordnung mit wenigstens einem OLED-Element (organische Leuchtdioden) und einem Schaltelement bekannt.

Aufgabe der vorliegenden Erfindung ist es, ausgehend von einer Eingabeeinheit der eingangs genannten Art, diese in einer solchen Weise zu konstruieren, dass sie technisch besonders wirkungsvoll und trotzdem kostengünstig ist, und dass ohne all zu großen Aufwand auch das Vorsehen von Beleuchtungselementen möglich ist.

Diese Aufgabe wird erfindungsgemäß durch eine Eingabeeinheit gelöst, die die Merkmale des kennzeichnenden Teils der unabhängigen Ansprüche 1-3 aufweist.

Danach ist die Eingabeeinheit auf einer starren Leiterplatte montiert. Die Sensorfolie ist eine transparente ITO-Folie, eine gelochte PEF oder eine gelochte FPC-Folie. Die Abdeckung ist zumindest an ausgewählten Stellen transparent ausgebildet. Auf der Leiterplatte sind an ausgewählten Stellen durch die Elektronik auf der Leiterplatte schaltbar schaltbare Leuchtdioden angeordnet. Zwischen der Sensorfolie und der Leiterplatte ist unterhalb der Sensorfolie eine transparente Tastaturmatte und unter der Tastaturmatte eine Metalldom- oder Polydomfolie angeordnet. Die jeweiligen Dome der Polydomfolie sind jeweilig einem elektrischen Kontakt auf der Leiterplatte zugeordnet. Außerdem sind die jeweiligen Dome jeweilig über die Abdeckung beispielsweise mit dem Finger durch Druck auf die Abdeckung an einer betreffenden Stelle mechanisch betätigbar in der Weise, dass bei einer Betätigung eines solchen Doms der jeweils zugeordnete elektrische Kontakt auf der Leiterplatte betätigt ist. In der Metalldom- oder Polydomfolie sind Aussparungen vorgesehen, die den jeweiligen Leuchtdioden auf der Leiterplatte in der Weise zugeordnet sind, dass durch die Leuchtdioden ein Beleuchten ausgewählter transparenter Stellen der Abdeckung durch die transparente Tastaturmatte und transparente oder gelochte Sensorfolie hindurch sichergestellt ist.

Eine solche Eingabeeinheit ist besonders wirkungsvoll, weil die für die Wirkung maßgebliche Widerstandsstruktur maximal nah an der Abdeckfläche angeordnet ist und eine Fingerberührung der Abdeckfläche direkt technischen Einfluss auf die Widerstandsstruktur der Sensorfolie ausübt.

Weiter ist eine solche Eingabeeinheit kostengünstig, weil eine solche Sensorfolie in besonders einfacher Weise herzustellen und daher preiswert ist.

Schließlich können auch Beleuchtungselemente berücksichtigt werden, die dazu beitragen, dass die Eingabeeinheit besonders wirkungsvoll ist. Beispielsweise es möglich, Beleuchtungselemente mit entsprechender Anschlussmöglichkeit direkt auf der Sensorfolie anzuordnen. Erfindungsgemäß ist vorgesehen, Beleuchtungselemente unterhalb des Überdeckungsbereichs der Sensorfolie vorzusehen und die Sensorfolie für einen Lichtdurchtritt zur Beleuchtung der Abdeckfläche an den gewünschten Stellen an den betreffenden Stellen transparent oder gelocht zu realisieren.

Die Eingabeeinheit umfasst damit in jedem Fall eine Sensortaste, die gegebenenfalls zusätzlich beleuchtet sein kann.

Die Sensorfolie kann zum Beispiel mit doppelseitigen Klebefolien eingeklebt werden. Sie kann mit einem entsprechenden Stecker, zum Beispiel einem an sich bekannten ZIF- oder Board-to-Board-Stecker, mit einer vorhandenen Leiterplatte, zu Beispiel einer Basis-Leiterplatte, kontaktiert werden.

Mit der speziellen Widerstandsstruktur auf der Sensorfolie kann auf kapazitivem Weg die Fingerposition auf der Abdeckung ermittelt werden. Dabei wird der Widerstand an drei Stellen abgegriffen. Jede dieser drei Stellen ist über eine Leiterbahn an eine zugehörige Kontaktstelle geführt. Über den bereits erwähnten entsprechenden Stecker sind diese Leiterbahnen auf die betreffende Leiterplatte geführt. Auf dieser Leiterplatte befindet sich Elektronik, zum Beispiel in Form eines speziellen Sensorchips mit zugehöriger Steuerungs-Hardware und -Software. Diese Elektronik kontrolliert und ermittelt die Signale, die mit der Fingerberührung auf der Abdeckung erzeugt werden, und formt diese Signale in entsprechende Reaktionen seitens des zu Grunde liegenden elektrischen Geräts um. Beispielsweise kann damit ein Cursor in einer Display-Anzeige gesteuert werden, oder es kann innerhalb eines ablaufenden Programms von einem Menü in ein anderes gesprungen werden.

Vorteilhafte Ausgestaltungen der Erfindung sind Gegenstand von Unteransprüchen.

Danach kann die Abdeckung durch eine Hartkappe gebildet sein. Diese kann separat von anderen Teilen konstruiert sein. Sie kann zum Beispiel aus einem für kapazitive Feldübertragungen günstigeren Material gefertigt sein als ein weiteres Gehäuse, in das die Eingabeeinheit eingebaut ist. Sie kann austauschbar sein, um unterschiedliche Design-Varianten gegebenenfalls auch noch nachträglich realisieren zu können.

Für die Eingaben mit dem Finger kann der Berührbereich der Abdeckung beispielsweise linear ausgeführt sein. Damit lassen sich beispielsweise durch Verschieben des Fingers auf dem Berührbereich Eingaben steuern, die einem linearen Schieberegler entsprechen. Kombiniert mit Beleuchtungselementen läßt sich auf dem Berührbereich rückwirkend die gerade aktuelle Position des Schiebereglers optisch anzeigen.

Es sind neben einer solchen linearen Ausgestaltung der Eingabeeinheit aber auch kurvenförmige oder kreisringförmige Ausgestaltungen realisierbar.

Die kurvenförmige Ausgestaltung kann beispielsweise aus Gründen des Designs gewählt sein.

Die kreisringförmige Ausgestaltung kann beispielsweise aus Gründen einer Nachbildung eines Drehknopfs gewählt sein.

Insbesondere Letzteres hat den Vorteil, dass ohne ein Absetzen des Fingers vom Berührbereich eine einmal begonnene Eingabe für längere Zeit kontinuierlich fortgesetzt werden kann. Die kontinuierliche Fortsetzung der Eingabe erkennt ohne weiteres die entsprechend dafür konzipierte Software, die dann dafür sorgt, dass ebenfalls kontinuierlich in der einmal begonnenen Reaktion weiter gemacht wird, bis schließlich der Finger wenigstens kurzzeitig von der Berührfläche abgehoben wird.

Die Elektronik für die Auswertung der Eingaben über die erfindungsgemäße Eingabeeinheit ist erfindungsgemäß auf einer starren Basis-Leiterplatte angeordnet. Diese kann gleichzeitig dazu verwendet werden, auch die Eingabeeinheit darauf zu platzieren. Es wird somit insgesamt nur eine einzige starre Leiterplatte als ein Träger benötigt.

Erfindungsgemäß ist die Sensorfolie eine transparente ITO-Folie (Indiumzinnoxid-Folie), eine gelochte so genannte PET-Folie (Polyethylenterephthalat-Folie; Folie aus einem thermoplastischen Kunststoff aus der Familie der Polyester) oder eine gelochte FPC-Folie (Flexible Printed Circuit; Folie, die einer flexiblen Leiterplatte entspricht).

Die Widerstandsstruktur auf den gelochten PET und FPC Sensorfolien kann zum Beispiel ein Karbon- oder Silberdruck sein, der sich sehr leicht aufbringen lässt. Andere Realisierungsmöglichkeiten sind aber ebenfalls denkbar.

Werden Beleuchtungsmittel im Zusammenhang mit der Eingabeeinheit verwendet, ist die Abdeckung wenigstens einzig an den dafür notwendigen Stellen transparent ausgebildet. Die Realisierung solcher Stellen ist technisch kein Problem. Der elektrische Anschluss und das entsprechende gesteuerte Schalten dieser Beleuchtungsmittel ist technisch ebenfalls kein Problem.

Erfindungsgemäß zwischen der Sensorfolie und der Leiterplatte unterhalb der Sensorfolie eine Tastaturmatte und unter der Tastaturmatte eine Metalldom- oder Polydomfolie angeordnet. Die jeweiligen Dome der Metalldom- oder Polydomfolie sind jeweilig einem elektrischen Kontakt auf der starren Leiterplatte, zum Beispiel der oben angesprochenen Basis-Leiterplatte, zugeordnet. Dabei sind diese jeweiligen Dome jeweilig über die Abdeckung mechanisch betätigbar und zwar in der Weise, dass bei einer Betätigung eines solchen Doms über die entsprechende Stelle auf der Abdeckung beziehungsweise Berührfläche, initiiert durch einen entsprechenden Fingerdruck, der jeweils zugeordnete elektrische Kontakt auf der Leiterplatte beziehungsweise Basis-Leiterplatte betätigt ist.

Dies ist möglich, weil die dünne, die Berührfläche bereitstellende Abdeckung flexibel ist. Auch die Tastaturmatte ist flexibel. Sie ist aus einem Silikon-Material gefertigt. Weiter sind auch die Dome der Metalldom- oder Polydomfolie flexibel, weil es gerade ihre Aufgabe ist, unter Druck einzuknicken und einen elektrischen Kontakt auszuüben.

Damit ist es möglich, mit der erfindungsgemäßen Eingabeeinheit zusätzlich auch mechanische Betätigungen zu ermöglichen. Für deren Realisierung ist letztlich ein herkömmlicher Aufbau bestehend im Wesentlichen aus einer flexiblen Tastaturmatte, gegebenenfalls bestückt mit Hartkappen an den jeweiligen Tastenpunkten, und einer Betätigungsfolie, sprich einer Metalldom- oder einer Polydomfolie, verwendbar. Unter Umständen ist unter der Metalldom- oder Polydomfolie noch eine Abstandsfolie, auch Spacerfolie genannt, platziert.

Insgesamt ist damit wieder eine Eingabeeinheit zur Verfügung gestellt, die sensormechanisch und mit Beleuchtung funktioniert.

Die Widerstandsstruktur auf der Sensorfolie kann mit bestückten Widerständen oder mit aufgedruckten Widerständen realisiert sein.

Bei einer kreisringförmigen Eingabeeinheit können mit dem Finger auf dem Berührbereich ausgeführte Kreisbewegungen erfasst werden.

Außerdem kann bei einer solchen Eingabeeinheit im Zentrum des kreisringförmig ausgebildeten Berührbereichs zusätzlich ein mechanisch betätigbarer Druckschalter angeordnet sein.

Zur Erfassung der Position des Fingers auf dem Berührbereich ist die Widerstandsstruktur in eine Vielzahl von einzelnen Bereichen unterteilt, die jeweils absoluten Positionen entsprechen. Eine jeweilige zu einer aktuellen Fingerberührung gehörende aktuelle Widerstandsgröße ist dabei in Relation zur Widerstandsgröße einer entsprechenden absoluten ersten und einer entsprechenden absoluten letzten Position ermittelt. Mit anderen Worten, die Widerstandsstruktur funktioniert quasi wie ein einstellbares Potentiometer, jedoch mit kapazitiven Größen. Abgegriffen wird der jeweils aktuell eingestellte Wert. Entsprechend dem aktuellen Wert wird dann beispielsweise die Position eines Cursors gesteuert.

Die erfindungsgemäße Eingabeeinheit kann in besonders vorteilhafter Weise in einem Telefon eingebaut werden, welches die Funktionalitäten eines Computers hat und dazu unter anderem auch ein Display aufweist, auf dem eine Informationsanzeige entsprechend einem solchen Computer stattfindet. Nachfolgend wird ein Ausführungsbeispiel der Erfindung anhand einer Zeichnung näher erläutert. Darin zeigen:
- Figur 1: einen Schnitt durch ein Ausführungsbeispiel einer erfindungsgemäßen Eingabeeinheit,
- Figur 2: eine dreidimensionale Explosionsdarstellung der wichtigsten Teile der Eingabeeinheit nach Figur 1,
- Figur 3: eine Draufsicht in dreidimensionaler Darstellung auf die Teile nach der Figur 2 in einem zusammengefügten Zustand,
- Figur 4: eine dreidimensionale Draufsicht auf die Teile nach der Figur 3 mit entfernter Abdeckung und Sensorfolie,
- Figur 5: eine Unteransicht der in der Figur 4 entfernten Sensorfolie und Abdeckung,
- Figur 6: ein erstes Ausführungsbeispiel einer Sensorfolie, wie sie in den Figuren 1, 2, 3 oder 5 verwendet sein kann, und
- Figur 7: ein zweites Ausführungsbeispiel einer Sensorfolie, wie sie in den Figuren 1, 2, 3 oder 5 verwendet sein kann.

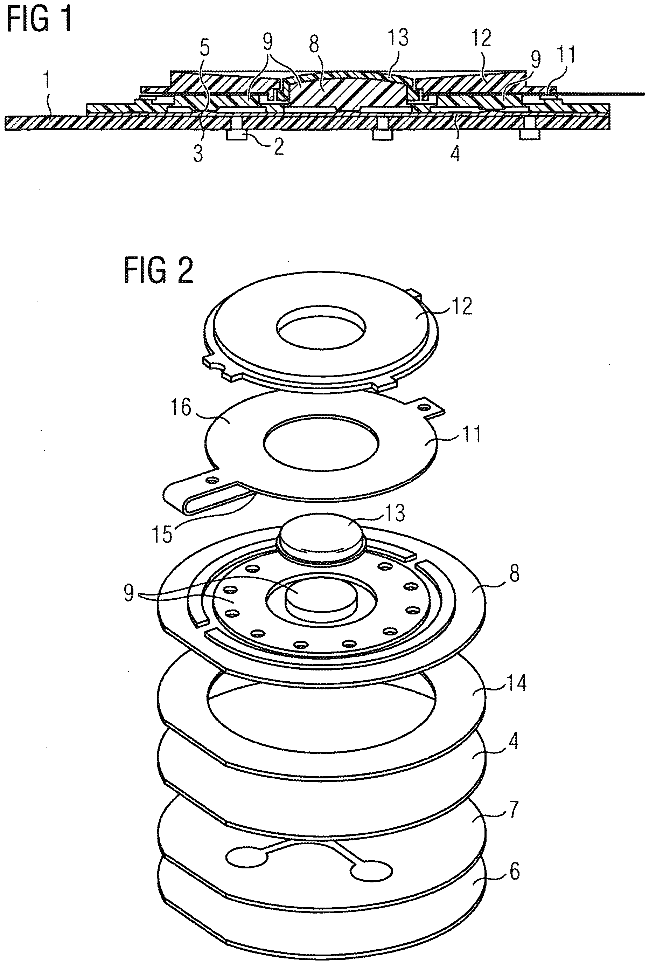

In der Figur 1 sind eine starre Leiterplatte beziehungsweise Basis-Leiterplatte 1 zu sehen, auf deren Unterseite Beleuchtungselemente in Form von Leuchtdioden 2 angeordnet sind. Die Leuchtdioden 2 sind auf der Unterseite der besagten Leiterplatte 1 bestückt und elektrisch angeschlossen und ragen durch eine Öffnung in der besagten Leiterplatte 1 in einer Art, dass die Leuchtdioden 1 nach oberhalb der besagten Leiterplatte 1 ihr Licht abstrahlen können.

Auf der Leiterplatte 1 ist neben den nachfolgend näher beschriebenen Elementen wenigstens auch eine Elektronik umfassend Hard- und Software angeordnet, die es gestattet, die mit der auf die Leiterplatte 1 montierten Eingabeeinheit hervorgerufenen Eingangssignale auszuwerten und in entsprechende Reaktionen wie zum Beispiel eine entsprechende Cursor-Steuerung auf einem Display oder einer entsprechenden Funktonsausführung umzusetzen.

Die Leiterplatte 1 weist elektrische Kontakte 3 auf der Oberseite auf. Über den Bereich der elektrischen Kontakte 3 ist eine Metalldom- oder Polydomfolie 4 mit jeweiligen Domen 5 angeordnet. Die einzelnen Dome 5 der Metalldom- oder Polydomfolie 4 sind jeweils den elektrischen Kontakten 3 auf der Leiterplatte 1 zugeordnet, so dass bei einer Betätigung der Dome 5 ein elektrischer Kontakt 3 auf der Leiterplatte 1 geschlossen wird.

Zwischen der Metalldom- oder Polydomfolie 4 und der Leiterplatte kann eine Trennfolie 6 und eine Abstandsfolie 7 (Figur 2) angeordnet sein, die aber in der Figur 1 nicht näher kenntlich gemacht ist.

Oberhalb der Metalldom- oder Polydomfolie 4 ist eine aus Silikon bestehende Tastaturmatte 8 mit Druckkörpern 9 und jeweils zugehörigen Stößeln 10 für die Betätigung eines jeweiligen Doms 5 der Metalldom- oder Polydomfolie 4 angeordnet.

Die Struktur mit den elektrischen Kontakten 3 auf der Leiterplatte 1, der Metalldom- oder Polydomfolie 4, der Trennfolie 6 und der Abstandsfolie 7 (so genannte Spacerfolie), sofern vorhanden, und der Tastaturmatte 8 ist kreisringförmig ausgebildet. Dabei ist auch dem Zentrum der kreisringförmigen Struktur ein elektrischer Kontakt 3 auf der Leiterplatte 1, ein Dom 5 der Metalldom- oder Polydomfolie 4 und ein Druckkörper 9 der Tastaturmatte 8 mit zugehörigem Stößel 10 zugeordnet.

Auf der kreisringförmigen Tastaturmatte 8 ist eine entsprechend kreisringförmige Sensorfolie 11 angeordnet.

Auf der kreisringförmigen Sensorfolie 11 ist eine entsprechend kreisringförmige Abdeckung 12 angeordnet, die im vorliegenden Ausführungsbeispiel eine kreisringförmige Hartkappe ist.

Im Zentrum der kreisringförmigen Struktur ist auf einem Druckkörper 9 der Tastaturmatte 8 eine Hartkappe 13 angeordnet.

Zwischen der Tastaturmatte 8 und der Metalldom- oder Polydomfolie 4 kann eine doppelseitige Klebefolie 14 (Figur 2) angeordnet sein, die in der Figur 1 ebenfalls nicht näher kenntlich gemacht ist.

Damit die durch die Leuchtdioden 2 bewerkstelligte Beleuchtung wirksam sein kann, weist die Metalldom- oder Polydomfolie 4 an den entsprechenden Stellen Durchbrüche auf, die beispielsweise durch gestanzte Löcher realisiert sein können.

Ferner sind die Tastaturmatte 8 und auch die Sensorfolie 11 transparent ausgebildet. Schließlich sind auch wenigstens diejenigen Stellen der kreisringförmigen Hartkappe 12 transparent ausgebildet, an denen eine Druckbetätigung auf einen elektrischen Kontakt 3 auf der Leiterplatte 1 optisch kenntlich gemacht werden soll.

Soweit auch eine Trennfolie 6, eine Abstandsfolie 7 oder eine Klebefolie 14 eingesetzt sind, sind auch diese Folien entweder transparent ausgebildet oder weisen einen entsprechenden Durchbruch für einen Lichtdurchtritt des Lichts der betreffenden Leuchtdiode 2 an den betreffenden Stellen auf.

In der Figur 2 sind in der angegebenen Reihenfolge von oben nach unten im Einzelnen gezeigt: eine kreisringförmige Hartkappe 12, eine kreisringförmige Sensorfolie 11 mit Kontaktstellen 15 für eine elektrische Kontaktierung der auf der Sensorfolie 11 angeordneten Widerstandsstruktur 16, eine Tastaturmatte 8 mit einer Hartkappe 13 für den im Zentrum angeordneten Druckkörper 9, eine Klebefolie 14, eine Metalldom- oder Polydomfolie 4, eine Abstandsfolie 7 und eine Trennfolie 6.

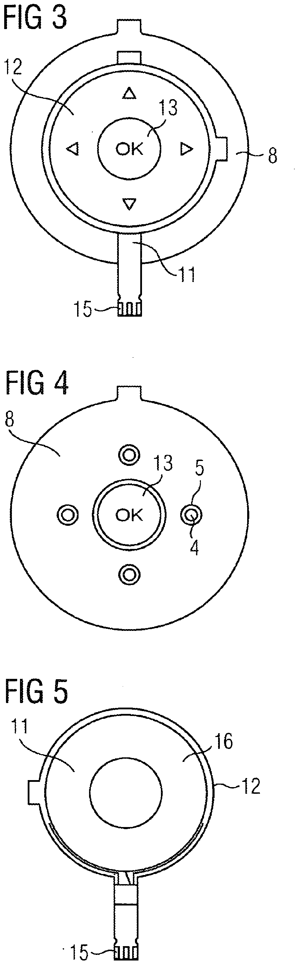

In der Figur 3 ist insbesondere die Hartkappe 12 zu erkennen, unter der die Sensorfolie 11 angeordnet ist. Ferner sind die Kontaktstellen 15 der Sensorfolie 11 kenntlich gemacht. Unter der Sensorfolie 11 ist die Tastaturmatte 8 angeordnet. Im Zentrum der kreisringförmigen Hartkappe 12 ist die weitere Hartkappe 13 angeordnet.

In der Figur 4 ist die im Zentrum angeordnete Hartkappe 13 zu sehen, die im Zentrum auf die Tastaturmatte 8 gesetzt ist. Unterhalb der Tastaturmatte 8 ist die Metalldom- oder Polydomfolie 4 angeordnet mit den Domen 5. Im vorliegenden Ausführungsbeispiel ist die Metalldom- oder Polydomfolie 4 soweit reduziert ausgebildet, dass praktisch nur noch die Dome 5 miteinander verbunden sind. Auf diese Weise ist es gegebenenfalls nicht mehr nötig, noch extra Durchbrüche für einen Lichtdurchtritt für Leuchtdioden 2 vorzusehen.

In der Figur 5 ist die Sensorfolie 11 zu sehen, auf deren Unterseite zum einen die Widerstandsstruktur 16 angeordnet ist und durch die transparente Sensorfolie 11 scheint, und ist zum anderen die kreisringförmige Hartkappe 12 angeordnet. An einem zungenartigen Fortsatz der Sensorfolie 11 sind die Kontaktstellen 15 der Sensorfolie 11 zu sehen.

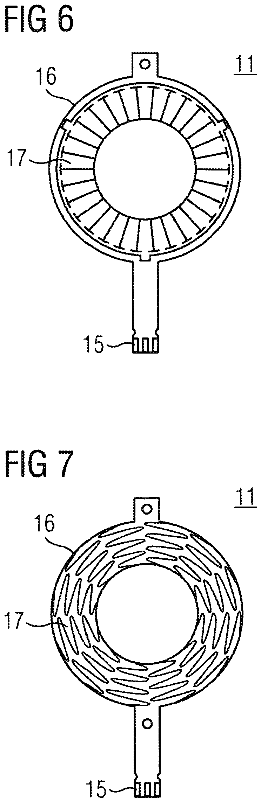

In den Figuren 6 und 7 sind je ein Ausführungsbeispiel einer Sensorfolie 11 mit den Kontaktstellen 15 und einer jeweiligen Widerstandsstruktur 16 zu sehen.

In der Figur 6 weist die Widerstandsstruktur 16 im Kreis aneinander gereihte Einzelbereiche 17 auf, die alle zusammen elektrisch verkettet und mit einer der Kontaktstellen 15 elektrisch verbunden sind. Die Einzelbereiche 17 stellen jeweils eine entsprechende absolute Position dar. Ferner ist eine absolut erste Position der Widerstandsstruktur 16 mit einer anderen der Kontaktstellen 15 elektrisch verbunden. Schließlich ist eine absolut letzte Position der Widerstandsstruktur 16 mit einer weiteren der Kontaktstellen 15 verbunden. Die jeweiligen absoluten Positionen und die Einzelbereiche 17 sind untereinander in der Weise elektrophysikalisch miteinander verbunden, dass an den Kontaktstellen 15 kapazitive Widerstände abgreifbar sind.

Für die Figur 7 gilt Entsprechendes wie für die Figur 6, allerdings mit einer Widerstandsstruktur 16, die fingerartig ineinander greifende Bereiche aufweist und nicht ein Karbondruck wie in der Figur 6 sondern eine metallische Realisierung sind.

## Patentansprüche

1. Eingabeeinheit für elektrotechnische Geräte, aufweisend mit dem menschlichen Finger bedienbare Komponenten zur elektromechanischen und/oder elektronischen Erzeugung von Eingangssignalen für eine kontrollierte Steuerung des elektrotechnischen Geräts basierend auf diesen erzeugten Eingangssignalen, wobei für die Fingerberührung eine für kapazitive Feldübertragungen geeignete Abdeckung vorgesehen ist, die einen Berührbereich aufweist für eine Berührung an mehr als an einer einzigen Stelle und direkt unterhalb dieser eine Sensorfolie mit einer über drei Kontaktstellen elektrisch kontaktierbaren Widerstandsstruktur vorgesehen ist, die kontinuierlich kapazitiv in Abhängigkeit von der momentanen Stelle der Berührung der Abdeckung durch den menschlichen Finger reagiert und eine jeweilige entsprechende Widerstandsgröße einstellt, die an den drei Kontaktstellen abgreifbar und zur Erzeugung eines jeweiligen zugehörigen Eingangssignals für das elektrotechnische Gerät zu dessen jeweils entsprechender Steuerung heranziehbar ist, **dadurch gekennzeichnet, dass** sie auf einer starren Leiterplatte (1) montiert ist, dass die Sensorfolie (11) eine transparente ITO-Folie ist, dass die Abdeckung (12) zumindest an ausgewählten Stellen transparent ausgebildet ist, dass auf der Leiterplatte (1) an ausgewählten Stellen durch Elektronik auf der Leiterplatte (1) schaltbar schaltbare Leuchtdioden (2) angeordnet sind, dass zwischen der Sensorfolie (11) und der Leiterplatte (1) unterhalb der Sensorfolie (11) eine transparente Tastaturmatte (8) und unter der Tastaturmatte (8) eine Metalldom- oder Polydomfolie (4) angeordnet ist, deren jeweiligen Dome (5) jeweilig einem elektrischen Kontakt (3) auf der Leiterplatte (1) zugeordnet sind und deren jeweiligen Dome (5) jeweilig über die Abdeckung (12) mechanisch betätigbar sind in der Weise, dass bei einer Betätigung eines solchen Doms (5) der jeweils zugeordnete elektrische Kontakt (3) auf der Leiterplatte (1) betätigt ist, und dass in der Metalldom- oder Polydomfolie (4) Aussparungen vorgesehen sind, die den jeweiligen Leuchtdioden (2) auf der Leiterplatte (1) in der Weise zugeordnet sind, dass durch die Leuchtdioden (2) ein Beleuchten ausgewählter transparenter Stellen der Abdeckung (12; 13) durch die transparente Tastaturmatte (8) und transparente Sensorfolie hindurch sichergestellt ist.

2. Eingabeeinheit für elektrotechnische Geräte, aufweisend mit dem menschlichen Finger bedienbare Komponenten zur elektromechanischen und/oder elektronischen Erzeugung von Eingangssignalen für eine kontrollierte Steuerung des elektrotechnischen Geräts basierend auf diesen erzeugten Eingangssignalen, wobei für die Fingerberührung eine für kapazitive Feldübertragungen geeignete Abdeckung vorgesehen ist, die einen Berührbereich aufweist für eine Berührung an mehr als an einer einzigen Stelle und direkt unterhalb dieser eine Sensorfolie mit einer über drei Kontaktstellen elektrisch kontaktierbaren Widerstandsstruktur vorgesehen ist, die kontinuierlich kapazitiv in Abhängigkeit von der momentanen Stelle der Berührung der Abdeckung durch den menschlichen Finger reagiert und eine jeweilige entsprechende Widerstandsgröße einstellt, die an den drei Kontaktstellen abgreifbar und zur Erzeugung eines jeweiligen zugehörigen Eingangssignals für das elektrotechnische Gerät zu dessen jeweils entsprechender Steuerung heranziehbar ist, **dadurch gekennzeichnet, dass** sie auf einer starren Leiterplatte (1) montiert ist, dass die Sensorfolie (11) eine PET-Folie ist, die an entsprechenden Stellen für einen Lichtdurchtritt zur Beleuchtung der Abdeckung an vorgegebenen Stellen gelocht ist, dass auf der Leiterplatte (1) an ausgewählten Stellen durch Elektronik auf der Leiterplatte (1) schaltbar schaltbare Leuchtdioden (2) angeordnet sind, dass zwischen der Sensorfolie (11) und der Leiterplatte (1) unterhalb der Sensorfolie (11) eine transparente Tastaturmatte (8) und unter der Tastaturmatte (8) eine Metalldom- oder Polydomfolie (4) angeordnet ist, deren jeweiligen Dome (5) jeweilig einem elektrischen Kontakt (3) auf der Leiterplatte (1) zugeordnet sind und deren jeweiligen Dome (5) jeweilig über die Abdeckung (12) mechanisch betätigbar sind in der Weise, dass bei einer Betätigung eines solchen Doms (5) der jeweils zugeordnete elektrische Kontakt (3) auf der Leiterplatte (1) betätigt ist, und dass in der Metalldom- oder Polydomfolie (4) Aussparungen vorgesehen sind, die den jeweiligen Leuchtdioden (2) auf der Leiterplatte (1) in der Weise zugeordnet sind, dass durch die Leuchtdioden (2) ein Beleuchten ausgewählter transparenter Stellen der Abdeckung (12; 13) durch die transparente Tastaturmatte (8) und gelochte Sensorfolie hindurch sichergestellt ist.

3. Eingabeeinheit für elektrotechnische Geräte, aufweisend mit dem menschlichen Finger bedienbare Komponenten zur elektromechanischen und/oder elektronischen Erzeugung von Eingangssignalen für eine kontrollierte Steuerung des elektrotechnischen Geräts basierend auf diesen erzeugten Eingangssignalen, wobei für die Fingerberührung eine für kapazitive Feldübertragungen geeignete Abdeckung vorgesehen ist, die einen Berührbereich aufweist für eine Berührung an mehr als an einer einzigen Stelle und direkt unterhalb dieser eine Sensorfolie mit einer über drei Kontaktstellen elektrisch kontaktierbaren Widerstandsstruktur vorgesehen ist, die kontinuierlich kapazitiv in Abhängigkeit von der momentanen Stelle der Berührung der Abdeckung durch den menschlichen Finger reagiert und eine jeweilige entsprechende widerstandsgröße einstellt, die an den drei Kontaktstellen abgreifbar und zur Erzeugung eines jeweiligen zugehörigen Eingangssignals für das elektrotechnische Gerät zu dessen jeweils entsprechender Steuerung heranziehbar ist, **dadurch gekennzeichnet, dass** sie auf einer starren Leiterplatte (1) montiert ist, dass die Sensorfolie (11) eine FPC-Folie ist, die an entsprechenden Stellen für einen Lichtdurchtritt zur Beleuchtung der Abdeckung an vorgegebenen Stellen gelocht ist, dass auf der Leiterplatte (1) an ausgewählten Stellen durch Elektronik auf der Leiterplatte (1) schaltbar schaltbare Leuchtdioden (2) angeordnet sind, dass zwischen der Sensorfolie (11) und der Leiterplatte (1) unterhalb der Sensorfolie (11) eine transparente Tastaturmatte (8) und unter der Tastaturmatte (8) eine Metalldom- oder Polydomfolie (4) angeordnet ist, deren jeweiligen Dome (5) jeweilig einem elektrischen Kontakt (3) auf der Leiterplatte (1) zugeordnet sind und deren jeweiligen Dome (5) jeweilig über die Abdeckung (12) mechanisch betätigbar sind in der Weise, dass bei einer Betätigung eines solchen Doms (5) der jeweils zugeordnete elektrische Kontakt (3) auf der Leiterplatte (1) betätigt ist, und dass in der Metalldom- oder Polydomfolie (4) Aussparungen vorgesehen sind, die den jeweiligen Leuchtdioden (2) auf der Leiterplatte (1) in der Weise zugeordnet sind, dass durch die Leuchtdioden (2) ein Beleuchten ausgewählter transparenter Stellen der Abdeckung (12; 13) durch die transparente Tastaturmatte (8) und gelochte Sensorfolie hindurch sichergestellt ist.

4. Eingabeeinheit nach einem der Ansprüche 1 bis 3, **dadurch gekennzeichnet, dass** die Abdeckung (12) eine Hartkappe ist.

5. Eingabeeinheit nach einem der Ansprüche 1 bis 4, **dadurch gekennzeichnet, dass** der Berührbereich linear ausgebildet ist.

6. Eingabeeinheit nach einem der Ansprüche 1 bis 4, **dadurch gekennzeichnet, dass** der Berührbereich kurvenförmig ausgebildet ist.

7. Eingabeeinheit nach einem der Ansprüche 1 bis 4, **dadurch gekennzeichnet, dass** der Berührbereich kreisringförmig ausgebildet ist.

8. Eingabeeinheit nach einem der vorherigen Ansprüche, **dadurch gekennzeichnet, dass** auf der Leiterplatte (1) eine Elektronik platziert ist, die mit den drei Kontaktstellen (15) der Sensorfolie (11) verbunden ist und durch die in Abhängigkeit von den durch die Sensorfolie (11) kontinuierlich eingestellten Widerstandsgrößen jeweilige entsprechende Eingangssignale für das elektrotechnische Gerät zu dessen jeweils entsprechender Steuerung erzeugt sind.

9. Eingabeeinheit nach einem der vorherigen Ansprüche, **dadurch gekennzeichnet, dass** die widerstandsstruktur (16) ein Karbon- oder Silberdruck ist.

10. Eingabeeinheit nach Anspruch 7, **dadurch gekennzeichnet, dass** im Zentrum des kreisringförmig ausgebildeten Berührbereichs ein mechanisch betätigbarer Druckschalter angeordnet ist.

11. Eingabeeinheit nach einem der vorherigen Ansprüche, **dadurch gekennzeichnet, dass** die Widerstandsstruktur in eine Vielzahl von einzelnen, jeweils absoluten Positionen entsprechenden Bereiche (17) unterteilt ist und eine jeweilige zu einer aktuellen Fingerberührung gehörende aktuelle Widerstandsgröße in Relation zur Widerstandsgröße einer entsprechenden absoluten ersten und einer entsprechenden absoluten letzten Position ermittelt ist.

12. Eingabeeinheit nach einem der vorherigen Ansprüche, **dadurch gekennzeichnet, dass** sie in ein Telefons eingebaut ist.

## Claims

1. An input unit for electrotechnical devices, having components operable with the human finger for the electromechanical and/or electronic generation of input signals for a controlled actuation of the electrotechnical device based on these generated input signals, with a cover suitable for capacitive field movement being provided for the finger contact, said cover having a contact region for contact at more than one single location and directly beneath said cover there being provided a sensor film comprising a resistance structure that is electrically contactable via three contact points, said structure responding in a continually capacitive manner as a function of the then current location of the contact of the cover by a human finger and setting a respective corresponding resistivity that is measurable at the three contact points and can be used to generate a respectively associated input signal for the electrotechnical device for its respective corresponding actuation, **characterised in that** it is mounted on a rigid circuit board (1), that the sensor film (11) is a transparent ITO film, that the cover (12) is transparent in at least selected locations, that switchable light-emitting diodes (2) are arranged on the circuit board (1) in selected locations in a switchable manner by means of the electronics on the circuit board (1), that a transparent key pad (5) is located between the sensor film (11) and the circuit board (1) under the sensor film (11) and that under the key pad (8) there is disposed a metal dome or poly dome film (4) whose respective domes (5) are each assigned to an electrical contact (3) on the circuit board (1) and whose respective domes (5) are each mechanically actuatable via the cover (12) in such a manner that when actuating such a dome (5) the respectively assigned electrical contact (3) on the circuit board (1) is actuated, and that in the metal dome or poly dome film (4) there are provided recesses that are assigned to the respective light-emitting diodes (2) on the circuit board (1) in such a manner that illumination by the light-emitting diodes (2) of selected transparent locations of the cover (12, 13) is ensured through the transparent key pad (8) and the transparent sensor film.

2. An input unit for electrotechnical devices, having components operable with the human finger for the electromechanical and/or electronic generation of input signals for a controlled actuation of the electrotechnical device based on these generated input signals, with a cover suitable for capacitive field movement being provided for the finger contact, said cover having a contact region for contact at more than one single location and directly beneath said cover there being provided a sensor film comprising a resistance structure that is electrically contactable via three contact points, said structure responding in a continually capacitive manner as a function of the then current location of the contact of the cover by a human finger and setting a respective corresponding resistivity that is measurable at the three contact points and can be used to generate a respectively associated input signal for the electrotechnical device for its respective corresponding actuation, **characterised in that** it is mounted on a rigid circuit board (1), that the sensor film (11) is a PET film that is perforated in corresponding locations for the passage of light to illuminate the cover at predetermined locations, that switchable light-emitting diodes (2) are arranged on the circuit board (1) in selected locations in a switchable manner by means of the electronics on the circuit board (1), that a transparent key pad (5) is located between the sensor film (11) and the circuit board (1) under the sensor film (11) and that under the key pad (8) there is disposed a metal dome or poly dome film (4), whose respective domes (5) are each assigned to an electrical contact (3) on the circuit board (1) and whose respective domes (5) are each mechanically actuatable via the cover (12) in such a manner that when actuating such a dome (5) the respectively assigned electrical contact (3) on the circuit board (1) is actuated, and that in the metal dome or poly dome film (4) there are provided recesses that are assigned to the respective light-emitting diodes (2) on the circuit board in such a manner that illumination by the light-emitting diodes (2) of selected transparent locations of the cover (12, 13) is ensured through the transparent key pad (8) and the perforated sensor film.

3. An input unit for electrotechnical devices, having components operable with the human finger for the electromechanical and/or electronic generation of input signals for a controlled actuation of the electrotechnical device based on these generated input signals, with a cover suitable for capacitive field movement being provided for the finger contact, said cover having a contact region for contact at more than one single location and directly beneath said cover there being provided a sensor film comprising a resistance structure that is electrically contactable via three contact points, said structure responding in a continually capacitive manner as a function of the then current location of the contact of the cover by a human finger and setting a respective corresponding resistivity that is measurable at the three contact points and can be used to generate a respectively associated input signal for the electrotechnical device for its respective corresponding actuation, **characterised in that** it is mounted on a rigid circuit board (1), that the sensor film (11) is an FPC film that is perforated in corresponding locations for the passage of light to illuminate the cover at predetermined locations, that switchable light-emitting diodes (2) are arranged on the circuit board (1) in selected locations in a switchable manner by means of the electronics on the circuit board (1), that a transparent key pad (8) is located between the sensor film (11) and the circuit board (1) under the sensor film (11) and that under the key pad (8) there is disposed a metal dome or poly dome film (4), whose respective domes (5) are each assigned to an electrical contact (3) on the circuit board (1) and whose respective domes (5) are each mechanically actuatable via the cover (12) in such a manner that when actuating such a dome (5) the respectively assigned electrical contact (3) on the circuit board (1) is actuated, and that in the metal dome or poly dome film (4) there are provided recesses that are assigned to the respective light-emitting diodes (2) on the circuit board in such a manner that illumination by the light-emitting diodes (2) of selected transparent locations of the cover (12, 13) is ensured through the transparent key pad (8) and the perforated sensor film.

4. The input unit of any one of claims 1 to 3 wherein the cover is a hard cap.

5. The input unit of any one of claims 1 to 4 wherein the contact region is constructed to be linear.

6. The input unit of any one of claims 2 to 4 wherein the contact region is constructed to be curve-shaped.

7. The input unit of any one of claims 1 to 4 wherein the contact region is constructed to be circular ring-shaped.

8. The input unit of any one of the preceding claims, wherein the circuit board (1) comprises electronics that are connected with the three contact points (15) of the sensor film (11) and by means of which as a function of the resistivities set continually by the sensor film (11) respective corresponding input signals are generated for the electrotechnical device for its respective corresponding actuation.

9. The input unit of any one of the preceding claims, wherein the resistance structure (16) is a carbon or silver print.

10. The input unit of claim 7, wherein there is a mechanically actuatable pressure switch in the centre of the contact surface constructed in a circular ring-shape.

11. The input unit of any one of the preceding claims, wherein the resistance structure is subdivided into a plurality of individual regions (17) each corresponding to absolute positions and wherein a current resistivity associated with a current finger contact is generated in relation to the resistivity of a corresponding absolute first and a corresponding absolute last position.

12. The input unit of any one of the preceding claims, wherein it is built into a telephone.

## Revendications

1. Unité d'entrée pour appareils électrotechniques, présentant des composants pouvant être utilisés avec le doigt humain et servant à générer de manière électromécanique et/ou électronique des signaux d'entrée pour une commande contrôlée de l'appareil électrotechnique se basant sur lesdits signaux d'entrée générés, sachant qu'un revêtement approprié pour des transmissions de champ capacitives est prévu pour l'effleurement du doigt, lequel revêtement présente une zone d'effleurement pour effleurer plus d'un endroit et sous lequel directement est prévu un film détecteur pourvu d'une structure de résistance pouvant être contactée de manière électrique par l'intermédiaire de trois endroits de contact, laquelle structure de résistance réagit de manière capacitive en continu en fonction de l'endroit du revêtement effleuré sur le moment par le doigt humain et qui ajuste une grandeur de résistance respective correspondante, qui peut être prélevée au niveau des trois endroits de contact et à laquelle on peut avoir recours pour générer un signal d'entrée respectif associé pour la commande correspondante de l'appareil électrotechnique, **caractérisée en ce que** qu'elle est montée sur une carte de circuits imprimés (1) rigide, **en ce que** le film détecteur (11) est un film ITO transparent, **en ce que** le revêtement (12) est réalisé de manière transparente au moins au niveau d'endroits sélectionnés, **en ce que** des diodes électroluminescentes (2) pouvant être commutées par l'électronique sur la carte de circuits imprimés (1) sont disposées sur la carte de circuits imprimés (1) au niveau d'endroits sélectionnés, **en ce qu'**est disposé entre le film détecteur (11) et la carte de circuits imprimés (1) sous le film détecteur (11) un clavier (8) transparent, sous lequel clavier (8) est disposée une membrane à dôme en métal ou à poly dôme, dont chaque dôme est respectivement associé à un contact électrique (3) sur la carte de circuits imprimés (1) et dont chaque dôme peut être respectivement actionné mécaniquement par l'intermédiaire du revêtement (12) de telle manière que lors d'un actionnement d'un tel dôme (5), le contact électrique (3) respectivement associé est actionné sur la carte de circuits imprimés (1), et **en ce que** des évidements sont prévus dans la membrane à dôme en métal ou à poly dôme (4), lesquels évidements sont associés aux diodes électroluminescentes (2) respectives sur la carte de circuits imprimés (1) de telle manière, que les diodes électroluminescentes (2) permettent d'assurer un éclairement d'endroits transparents sélectionnés du revêtement (12 ; 13) à travers le clavier (8) transparent et le film détecteur transparent.

2. Unité d'entrée pour des appareils électrotechniques, présentant des composants pouvant être utilisés avec le doigt humain et servant à générer de manière électromécanique et/ou électronique des signaux d'entrée pour une commande contrôlée de l'appareil électrotechnique se basant sur lesdits signaux d'entrée générés, sachant que pour l'effleurement du doigt, un revêtement approprié pour les transmissions de champ capacitives est prévu, lequel revêtement présente une zone d'effleurement pour effleurer plus d'un endroit et directement sous lequel est prévu un film détecteur pourvu d'une structure de résistance pouvant être contactée électriquement par l'intermédiaire de trois endroits de contact, laquelle structure de résistance réagit de manière capacitive en continu en fonction de l'endroit du revêtement effleuré sur le moment par le doigt humain et ajuste une grandeur de résistance respective correspondante, qui peut être prélevée au niveau des trois endroits de contact et à laquelle on peut avoir recours pour générer un signal d'entrée respectivement associé pour la commande correspondante de l'appareil électrotechnique, **caractérisée en ce qu'**elle est montée sur une carte de circuits imprimés (1) rigide, **en ce que** le film détecteur (11) est un film PET, troué en des endroits correspondants pour laisser entrer la lumière pour éclairer le revêtement à des endroits prédéfinis, **en ce que** des diodes électroluminescentes (2) pouvant être commutées par l'électronique sur la carte de circuits imprimés (1) sont disposées sur la carte de circuits imprimés (1) à des endroits sélectionnés, **en ce qu'**est disposé entre le film détecteur (11) et la carte de circuits imprimés (1) sous le film détecteur (11) un clavier (8) transparent, sous lequel est disposée une membrane à dôme en métal ou à poly dôme (4), dont chaque dôme est respectivement associé à un contact électrique (3) sur la carte de circuits imprimés (1) et dont chaque dôme (5) respectif peut être respectivement actionné mécaniquement par l'intermédiaire du revêtement (12) de telle manière que lors d'un actionnement d'un tel dôme (5), le contact électrique (3) respectivement associé est actionné sur la carte de circuits imprimés (1), et **en ce que** des évidements sont prévus dans la membrane à dôme en métal ou à poly dôme (4), lesquels évidements sont associés aux diodes électroluminescentes (2) respectives sur la carte de circuits imprimés (1) de telle manière que les diodes électroluminescentes (2) permettent d'assurer un éclairement des endroits transparents sélectionnés du revêtement (12 ; 13) à travers le clavier (8) transparent et le film détecteur troué.

3. Unité d'entrée pour des appareils électrotechniques, présentant des composants pouvant être utilisés avec le doigt humain et servant à générer de manière électromécanique et/ou électronique des signaux d'entrée pour une commande contrôlée de l'appareil électrotechnique se basant sur lesdits signaux d'entrée générés, sachant que pour l'effleurement du doigt, un revêtement approprié pour des transmissions de champ capacitives est prévu, lequel présente une zone d'effleurement pour effleurer plus d'un endroit et directement sous lequel est prévu un film détecteur pourvu d'une structure de résistance pouvant être contactée électriquement par l'intermédiaire de trois endroits de contact, laquelle structure de résistance réagit de manière capacitive en continu en fonction de l'endroit du revêtement effleuré sur le moment par le doigt humain et ajuste une grandeur de résistance respective correspondante, laquelle peut être prélevée au niveau des trois endroits de contact et à laquelle on peut avoir recours pour générer un signal d'entrée respectif associé pour la commande respective correspondante de l'appareil électrotechnique, **caractérisée en ce qu'**elle est montée sur une carte de circuits imprimés (1) rigide, **en ce que** le film détecteur (11) est un film à circuit imprimé souple, troué en des endroits correspondants pour laisser entrer de la lumière servant à éclairer le revêtement à des endroits prédéfinis, **en ce que** des diodes électroluminescentes (2) pouvant être commutées par l'électronique de la carte de circuits imprimés (1) sont disposées sur la carte de circuits imprimés (1) à des endroits sélectionnés, **en ce qu'**est disposé entre le film détecteur (11) et la carte de circuits imprimés (1) sous le film détecteur (11) un clavier (8) transparent, sous lequel clavier (8) est disposée une membrane à dôme en métal ou à poly dôme (4), donc chaque dôme est associé respectivement à un contact électrique (3) de la carte de circuits imprimés (1) et dont chaque dôme (5) peut respectivement être actionné de manière mécanique par l'intermédiaire du revêtement (12) de telle manière que lors d'un actionnement d'un tel dôme (5), le contact électrique (3) respectivement associé sur la carte de circuits imprimés (1) est actionné, et **en ce que** sont prévus dans la membrane à dôme en métal ou à poly dôme (4) des évidements, lesquels sont associés aux diodes électroluminescentes (2) respectives sur la carte de circuits imprimés (1) de telle manière que les diodes électroluminescentes (2) permettent d'assurer un éclairement d'endroits transparents sélectionnés du revêtement (12 ; 13) à travers le clavier (8) transparent et le film détecteur troué.

4. Unité d'entrée selon l'une quelconque des revendications 1 à 3, **caractérisée en ce que** le revêtement (12) est un cache dur.

5. Unité d'entrée selon l'une quelconque des revendications 1 à 4, **caractérisée en ce que** la zone d'effleurement est réalisée de manière linéaire.

6. Unité d'entrée selon l'une quelconque des revendications 1 à 4, **caractérisée en ce que** la zone d'effleurement est réalisée de manière à présenter une forme courbée.

7. Unité d'entrée selon l'une quelconque des revendications 1 à 4, **caractérisée en ce que** la zone d'effleurement est réalisée de manière à présenter une forme d'anneau de cercle.

8. Unité d'entrée selon l'une quelconque des revendications précédentes, **caractérisée en ce qu'**une électronique est placée sur la carte de circuits imprimés (1), laquelle électronique est connectée aux trois endroits de contact (15) du film détecteur (11) et laquelle permet de générer en fonction des grandeurs de résistance ajustées en continu par le film détecteur (11), des signaux d'entrée respectifs pour la commande correspondantes de l'appareil électrotechnique.

9. Unité d'entrée selon l'une quelconque des revendications précédentes, **caractérisée en ce que** la structure de résistance (16) est une impression de carbone ou d'argent.

10. Unité d'entrée selon la revendication 7, **caractérisée en ce qu'**un commutateur de pression pouvant être actionné mécaniquement est disposé au centre de la zone d'effleurement réalisée de manière à présenter une forme d'anneau de cercle.

11. Unité d'entrée selon l'une quelconque des revendications précédentes, **caractérisée en ce que** la structure de résistance est divisée en une pluralité de différentes zones (17) correspondant respectivement à des positions absolues, et **en ce qu'**une grandeur de résistance réelle respective associée à un effleurement du doigt réel est déterminée par rapport à la grandeur de résistance d'une première position absolue correspondante et à une dernière position absolue correspondante.

12. Unité d'entrée selon l'une quelconque des revendications, **caractérisée en ce qu'**elle est intégrée dans un téléphone.
